# EUROPEAN PATENT APPLICATION

(11) **EP 2 214 199 A1**
(43) Date of publication of application: **04.08.2010**
(21) Application number: 10275003.1
(22) Date of filing: 20.01.2010
(51) Int. Cl.: H01L 21/3065, H01L 21/687, H01J 37/32

(54) **A method of plasma etching and carriers for use in such methods**

(30) Priority: 23.01.2009 GB 0901107
(71) Applicant: SPP Process Technology Systems UK Limited, Newport Gwent NP 10 8UJ (GB)
(72) Inventor: Tossell, David, Bristol, Avon BS20 7DU (GB)
(74) Representative: Dunlop, Brian Kenneth Charles

(57) **Abstract**

A method is for plasma etching elongate features in a generally planar workpiece of a type located in a chamber. The method includes etching a test workpiece in a flat configuration in the chamber, determining the respective angle of a longitudinal portion of the features relative to an axis passing orthogonally through the workpiece, and determining the curvature of the workpiece, which would have been required to reduce the angles, at least over a central portion of the workpiece, substantially to 0°. The method further includes processing a further workpiece of the same type whilst it is curved with the determined curvature.

## Description

This invention relates to methods of plasma etching and carriers for use in such processes.

A major preoccupation in all plasma etching processes is to seek to achieve the maximum uniformity in etched features across at least the central portion of a semi-conductor wafer. Many different techniques are known for improving this uniformity but in almost every chamber the ion density in the plasma is higher at the centre than nearer the walls of the chamber. The ions generating from this region in, at least the simplistic model, radiate from the centre of the plasma with the result that they impinge normally near the central axis of the wafer but, as the distance from this axis (the radius) increases, the ions impinge at an ever-increasing angle. This means that longitudinal portions of the features to be etched also tend to be inclined at an angle which increases with radius. To-date no adequate solution to this problem has been found. The Applicants have developed a method and a carrier which serve to at least mitigate this problem.

Thus from one aspect the invention consists in the method of plasma etching elongate features in a general planar workpiece (for example a semi-conductor wafer) of a type located in a chamber including:
(a) etching a test workpiece in a flat configuration in the chamber;
(b) determining the respective angle of a longitudinal portion of the features relative to an axis passing orthogonally through the workpiece;
(c) determining the curvature of the workpiece, which would have been required to reduce the angles, at least over a central portion of the workpiece substantially to 0°;
and
(d) processing a further workpiece of the same type whilst it is curved with the curvature determined at step (c).

What the Applicants have determined, is that the solution to the problem is not to fight to increase the homogeneity of the plasma but rather to determine empirically the effect of the lack of homogeneity in any particular chamber and then to orientate as much as the wafer as possible so that the ions impinging on the surface of the wafer at any part are substantially orthogonal.

The curvature may be achieved by retaining the further workpiece against a chuck or carrier having a concave part defining the desired curvature. The curved part of the chuck or carrier may have a surrounding land for retaining a workpiece in a flat orientation for step (a). The further wafer may initially be placed on the land and drawn down to the concave part for example by electrostatic attraction.

The chuck may be an electrostatic clumping chuck.

From another aspect the invention consists in a wafer carrier for mounting on a platen having a concave support surface for retaining a wafer in a concave orientation throughout an etching process.

Alternatively the wafer may be adhered to the support surface.

In either case the wafer carrier may include a circumferential land for supporting the wafer in an initial flat condition and the source of vacuum and/or electrostatic attraction for drawing the wafer onto the concave support surface prior to etching. The wafer carrier may be made at least in part of a dialetric e.g. alumina or sapphire. Preferably it may be of the same material as the electrostatic stack.

Although the invention has been described above it is to be understood it includes any inventive combination of the features set out above or in the following description.

The invention may be performed in various ways and specific embodiments will now be described, by way of example, with reference to the accompanying drawings, in which:
Figure 1 is a schematic view of a plasma etching chamber;
Figure 2 is an illustration of a wafer etched in a flat condition within the chamber of figure 1;
Figure 3 shows an equivalent wafer mounted on a concave carrier;
Figure 4 is a schematic illustration of the wafer shown in Figure 3 after etching and release from the carrier; and
Figure 5 illustrates how the dishing of the concave carrier can be calculated.

A plasma etching chamber is schematically indicated at 10. Means (not shown) are provided for striking a plasma 11 within the chamber, which overlies a platen 12 on which a wafer 13 can be supported on a carrier 14. A ceramic ring 15 is provided circumjacent the wafer location to reduce non-uniformity.

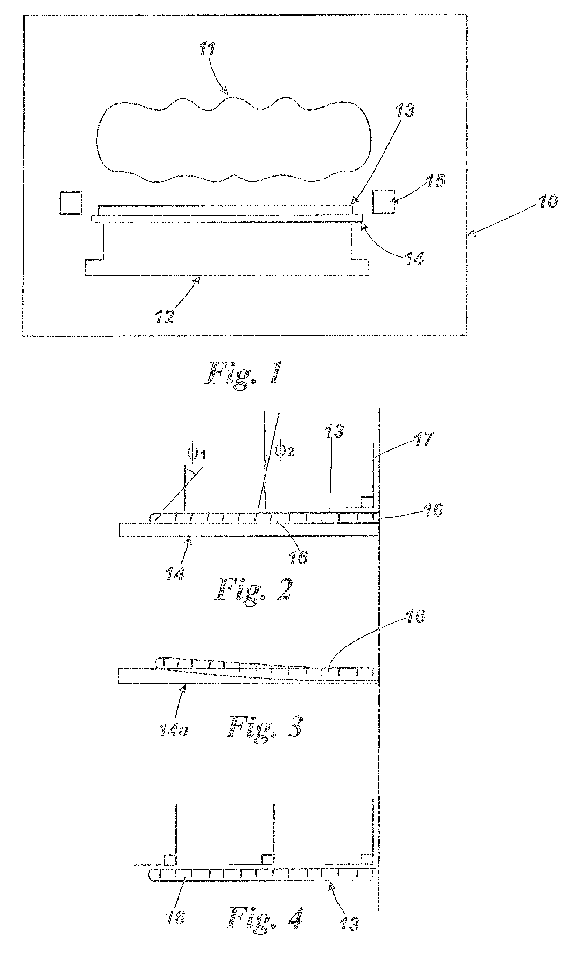

For the reasons explained above, the longitudinal features 16 (see Figure 2) etched into the wafer become progressively inclined to the central axis 17 due to the non-uniformity effect. As can be seen this angle of inclination becomes progressively greater as the radius from the axis 17 increases i.e. ∅₂ > ∅₁ Having appreciated that this relationship is radius dependent, the Applicants have determined that it can be counteracted by dishing the wafer 14 as shown in Figure 3. This is most simply achieved by providing a carrier 14a with a suitable concave support surface 18. When the wafer is removed from the carrier 14 it is formed as shown in Figure 4 where the longitudinal features 16 are orthogonal to the wafer surface and substantially parallel.

As plasma conditions tend to be very chamber dependent, the applicants have determined that the best way of utilizing this process is to process a wafer in the flat condition as shown in Figure 2, determine the values for the angles ∅ and from this determine the degree of dishing that is required in order to achieve the arrangement shown in Figure 3.

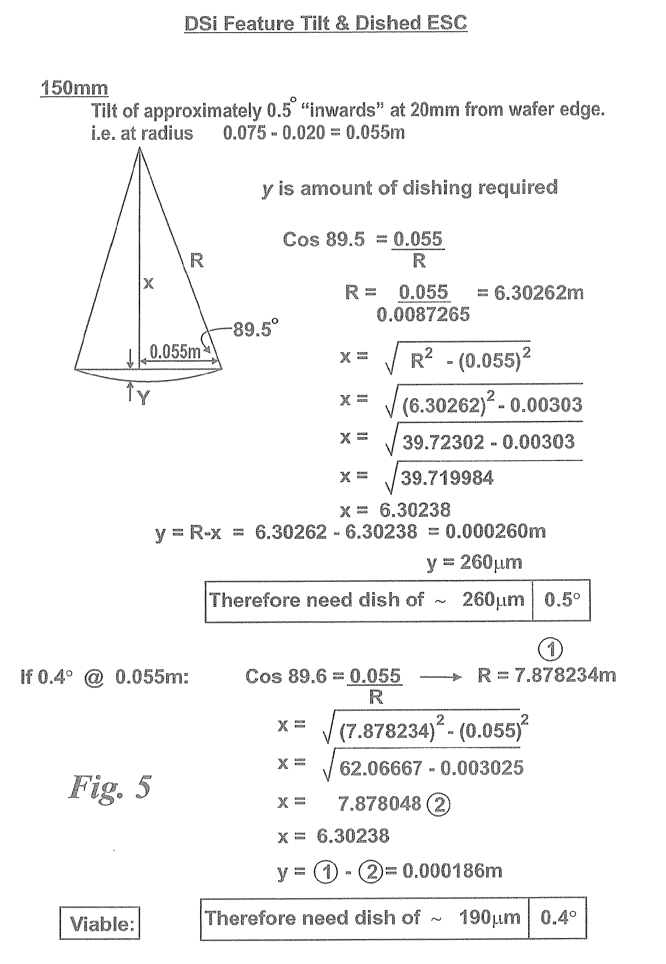

This can be computed using the diagram shown in Figure 5. This Figure also includes a worked example for 150mm radius wafer showing how the dimension of dishing (y) can be calculated for the concave surface on the wafer support 14a.

The platen 12 may be in the form of a high voltage electrostatic chick such as described in GB-A-23406591, which is incorporated herein by reference. The voltage use may, for example, range between 2k and 7k.

## Claims

1. A method of plasma etching elongate features in a generally plasma workpiece of a type located in a chamber including:
(a) etching a test workpiece in a flat configuration in the chamber;
(b) determining the respective angle of a longitudinal portion of the features relative to an axis passing orthogonally through the workpiece;
(c) determining the curvature of the workpiece, which would have been required to reduce the angles, at least over a central portion of the workpiece, substantially to 0°; and
(d) processing a further workpiece of the same type whilst it is curved with the curvature determined at step (c).

2. A method of claim 1 wherein the curvature is achieved by retaining the further workpiece against a chuck or carrier being a concave part defining the desired curvature.

3. A method as determined in claim 2 wherein the curved part of the chuck or carrier has a surrounding land for retaining a workpiece in a flat orientation for step (a).

4. A method as claimed in claim 3 wherein the further wafer is placed on the land and drawn down on to the concave part of the chuck by a vacuum and/or electrostatic attraction.

5. A method as claimed in any one of claims 2 to 5 wherein the chuck is an electrostatic clamping chuck.

6. A method as claimed in claim 5 wherein the chuck is held at between 2k and 7k volts.

7. A wafer carrier for mounting on a platen having a concave support surface for retaining a wafer in a concave orientation throughout an etching process.

8. A wafer carrier as claimed in claim 6 wherein the wafer is adhered to the support surface.

9. A wafer carrier as claimed in claim 7 including a circumferential land for supporting the wafer in an initial flat condition and a source of vacuum and/or electrostatic attraction for drawing the wafer onto the concave support surface prior to etching.
